# EUROPEAN PATENT APPLICATION

(11) **EP 2 234 149 A1**
(43) Date of publication of application: **29.09.2010**
(21) Application number: 08867407.2
(22) Date of filing: 31.12.2008
(51) Int. Cl.: H01L 21/677, H01L 21/687, H01L 21/67, H01L 21/673

(54) **SYSTEM AND PROCESS FOR CONVEYING WORKPIECES INTO A CHAMBER**

(30) Priority: 01.01.2008 US 968188
(71) Applicant: Dongguan Anwell Digital Machinery Co., Ltd., Guangdong 523081 (CN)
(72) Inventor: FAN, Chunwah, Dongguan Guangdong 523081 (CN)
(74) Representative: Bongiovanni, Simone
(86) International application number: PCT/CN2008/073904
(87) International publication number: WO 2009/082983

(57) **Abstract**

Techniques for transferring workpieces from one chamber to another chamber are disclosed. According to one aspect of the techniques, a treatment system includes a load lock chamber, a transfer chamber and one or more process chambers. The load lock chamber is provided to receive workpieces for treatment or process in one or more process chambers. The transfer chamber is provided as a mechanism to move workpieces from one chamber to another chamber. The process chamber includes a set of electrodes used to treat the workpieces with other materials. To facilitate the transfer of the workpieces, the process chamber is designed to position each of the workpieces vertically between a pair of electrodes, where each of the workpieces is removably held up by a fixture. Depending on implementation, the workpieces may be mounted on one fixture or multiple fixtures respectively. The fixture(s) is then mounted to a moving mechanism that facilitates the fixture(s) to move from one chamber to another chamber.

## Description

### FIELD OF THE INVENTION

The invention is generally related to the area of handling of multiple workpieces. More specially, the present invention is related to method and system for handling multiple workpieces from one chamber to another chamber, wherein the workpieces are being transferred, treated or processed in the chamber.

### BACKGROUND OF THE INVENTION

As always, the normal mechanism is usually used to handle and position objects. Under normal circumstances, when handling a plurality of objects, the normal mechanism needs to handle the objects in instalments, so that the handling process is longer. Furthermore, while the objects need to be processed in the chamber via the electrode, the objects are handled together with the electrode meanwhile, and the process would be more complicated using the normal mechanism. Moreover, in the case that the mechanism is far away from the objects, the problem of lacking route is generated. Therefore, an improved method for handling the objects is desired.

### SUMMARY OF THE INVENTION

This section is for the purpose of summarizing some aspects of the present invention and to briefly introduce some preferred embodiments. Simplifications or omissions in this section as well as in the abstract or the title of this description may be made to avoid obscuring the purpose of this section, the abstract and the title. Such simplifications or omissions are not intended to limit the scope of the present invention.

In general, the present invention pertains to techniques for transferring workpieces from one chamber to another chamber. According to one aspect of the present invention, a treatment system includes a load lock chamber, a transfer chamber and one or more process chambers. The load lock chamber is provided to receive workpieces for treatment or process in one or more process chambers. The transfer chamber is provided as a mechanism to move workpieces from one chamber to another chamber. The process chamber includes a set of electrodes used to treat the workpieces with other materials. The process chamber is designed to accommodate a platform that positions each of the workpieces vertically between a pair of planar electrodes. As a result, all workpieces are moved with the platform to be transferred, for example, from one chamber to another chamber. Depending on implementation, the platform may be implemented to include a fixture or a plurality of fixtures, where all of the workpieces may be removably held up by the fixture or each of the workpieces is removably held up by one of the fixtures. A moving mechanism is provided to facilitate the platform or fixture(s) to be moved from one chamber to another chamber.

According to another aspect of the present invention, the moving mechanism includes rollers, wheels running in rails and a transfer device, and studs and a manipulator. With a mechanical maneuver, the fixture(s) can be moved to a designated chamber through the moving mechanism.

The present invention may be implemented as a method, an apparatus, a system or a part of system. According to one embodiment, the present invention is a system for handling workpieces, the system comprises: a process chamber with a plurality of vertically aligned electrodes mounted in the process chamber; and a platform including a fixture or fixtures that is removably positioned in the chamber to hold a plurality of workpieces vertically.

According to another embodiment, the present invention is a system for handling workpieces in chambers, the system comprises: a load lock chamber for receiving the workpieces, wherein fixtures are used to hold the workpieces vertically apart; a transfer chamber including a rotary stage mounted with a transferring mechanism, the rotary stage being rotated to the load lock chamber to receive the fixture from the load lock chamber; at least a first process chamber. The transferring mechanism in the transfer chamber is used to transfer the fixture to the first process chamber and, when necessary, transfer the fixture from the first process chamber to the second process chamber.

The present invention may be used in a number of applications. One of them is to treat workpieces with chemical components. By employing one embodiment of the present invention, a number of workpieces may be processed simultaneously in a process chamber. When a different chemical process for the workpieces is needed, an additional process chamber may be provided. The transfer chamber may be used to efficiently transfer the workpieces from one process chamber to another one.

One of the objects, features, and advantages of the present invention is to provide a system for handling workpieces efficiently.

Objects, features, and advantages of the present invention will become apparent upon examining the following detailed description of an embodiment thereof, taken in conjunction with the attached drawings.

### BRIEF DESCRIPTION OF THE DRAWINGS

These and other features, aspects, and advantages of the present invention will become better understood with regard to the following description, appended claims, and accompanying drawings where:

FIG. 1 shows an exemplary configuration according to one embodiment of the present invention;

FIG. 2A and FIG. 2B show respectively a front view and a cross sectional view of a process chamber that includes a fixture and can be used in the configuration of FIG. 1;

FIG. 3A and FIG. 3B show respectively a front view and a cross sectional view of a process chamber that includes a plurality of fixtures and can be in the configuration of FIG. 1;

FIG. 4A and FIG. 4B show respectively a front view and a cross sectional view of a process chamber that includes a fixture with wheels running on a set of rails, and can also be used in the configuration of FIG. 1;

FIG. 5 shows an exemplary configuration using a transfer device to move a fixture from one chamber to another;

FIGS. 6A and 6B show respectively a front view and a cross sectional view of a process chamber that includes a fixture placed on a set of studs;

FIG. 7 shows a view of using a manipulator (e.g., a mechanical arm) to raise a fixture to move from one chamber to another; and

FIG. 8A and FIG. 8B together show a front view and cross sectional view of linear array arrangement of rod or tube type electrodes.

### DETAILED DESCRIPTION OF ILLUSTRATED EMBODIMENTS

The detailed description of the present invention is presented largely in terms of procedures, steps, logic blocks, processing, or other symbolic representations that directly or indirectly resemble the processing of workpieces in a chamber. These descriptions and representations are typically used by those skilled in the art to most effectively convey the substance of their work to others skilled in the art.

Reference herein to "one embodiment" or "an embodiment" means that a particular feature, structure, or characteristic described in connection with the embodiment can be included in at least one embodiment of the invention. The appearances of the phrase "in one embodiment" in various places in the specification are not necessarily all referring to the same embodiment, nor are separate or alternative embodiments mutually exclusive of other embodiments. Further, the order of blocks in process flowcharts or diagrams or the use of sequence numbers representing one or more embodiments of the invention do not inherently indicate any particular order nor imply any limitations in the invention.

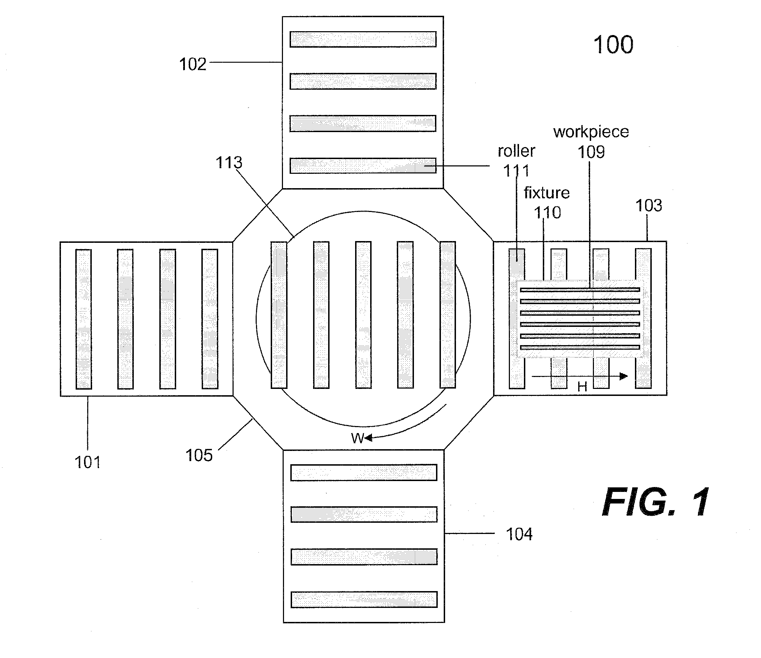

Referring now to the drawings, in which like numerals refer to like parts throughout the several views. FIG. 1 shows an exemplary configuration 100 according to one embodiment of the present invention. The configuration 100 includes a transfer chamber 105, one or more process chambers (only three representative chambers 102, 103 and 104 are shown) and one or more load lock chambers (only one representative chamber 101 is shown). As the name implies, a load lock chamber is used for receiving objects or workpieces and getting them ready for loading into one of the process chambers.

According to one embodiment, the transfer chamber 105 includes a rotary stage 113 that turns around to align with one of the process chambers to load or unload the workpieces. Depending on the implementation, the process chambers may be designed identically or each of the process chambers may be configured to treat the workpieces differently. For example, all available process chambers may be used together to treat workpieces simultaneously to increase the throughput. If a set of workpieces needs to be treated with two different types of chemical components, different chemical component may be loaded into each of the chambers. Thus a first process chamber is used to treat the workpieces with a first chemical component, a second process chamber is used to treat the workpieces with a second chemical component, where the transfer chamber 105 may be used to transfer the workpieces from the first process chamber to the second process chamber.

In one exemplary operation, an array of workpieces is removably positioned in a platform that may be moved in or out a chamber through a moving mechanism. The platform includes at least a fixture 110 that is loaded by the transfer chamber 105 into one of the process chambers. After the workpieces are processed, they are unloaded from the process chamber to the rotary stage on the transfer chamber. The rotary stage then rotates to a designated chamber (e.g., another one of the process chambers or the load lock chamber 101) to transfer the fixture therein. Depending on the implementation, the platform may be designed in different forms. Some exemplary platforms will be described below.

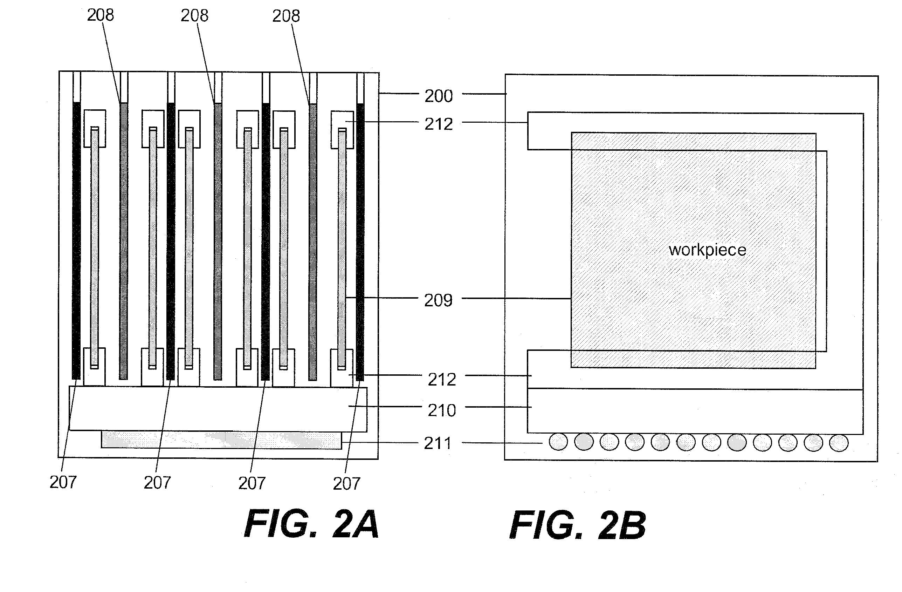

FIG. 2A and FIG. 2B show respectively a front view and a cross sectional view of a process chamber 200. According to one embodiment, the process chamber 200 is a housing with an opening on one end. The opening provides a mechanism to receive workpieces for treatment in the process chamber. There are a number of electrodes arranged in parallel in the process chamber 200. According to the embodiment shown in FIG. 2A, there are three planar RF electrodes 208 and four planar ground electrodes 207. To effectively use the planar electrodes, the three RF electrodes 208 and four ground electrodes 207 are arranged symmetrically. The electrode pairs are arranged back-to-back to each other. In other words, the RF electrode in the center shares in two electrode pairs. As a result, the three RF electrodes 208 interleave the four ground electrodes 207.

In one embodiment, these planar electrodes 207 and 208 are placed vertically but parallel to each other with a small space therebetween. Given the configuration shown in FIG. 2A, there are six workpieces 209 that can be positioned between two electrodes, one RF electrode and one ground electrode. The front surface of a workpiece, being a treatment surface, faces the RF electrode. The back surface of the workpiece is considered as a handling surface and positioned closer to the ground electrode. Because the gap between the back surface and the ground electrode is usually very small, a mechanical maneuver would be difficult, or displacement of the electrodes may be required in order to make room for handling the workpiece, which is mechanically complex and makes a process chamber large in size.

According to another embodiment, there are a number of outlets positioned on at least one of the electrodes, for example, to feed a type of gas (e.g., reactant gas) or a chemical component into a process chamber. These outlets may be distributed or arranged on the surface of an RF electrode facing another electrode. Thus when a workpiece is inserted between an RF electrode and a ground electrode, the gas or chemical component may effectively treat the workpiece.

As shown in FIG. 2A or 2B, a platform includes a fixture 210 and an array of rollers 211, where the fixture 210 is landed on the rollers 211. To allow for parallel handling of the workpieces, one fixture can hold a number of workpieces. The fixture 210, as shown, includes six sets of holders 212, each set designed to hold one of the workpieces to be treated in the process chamber. A pair of holders 212 is explicitly shown to hold a workpiece 209 in FIG. 2B. The fixture 200 allows all workpieces being held to be moved in or out, or between the process chambers simultaneously.

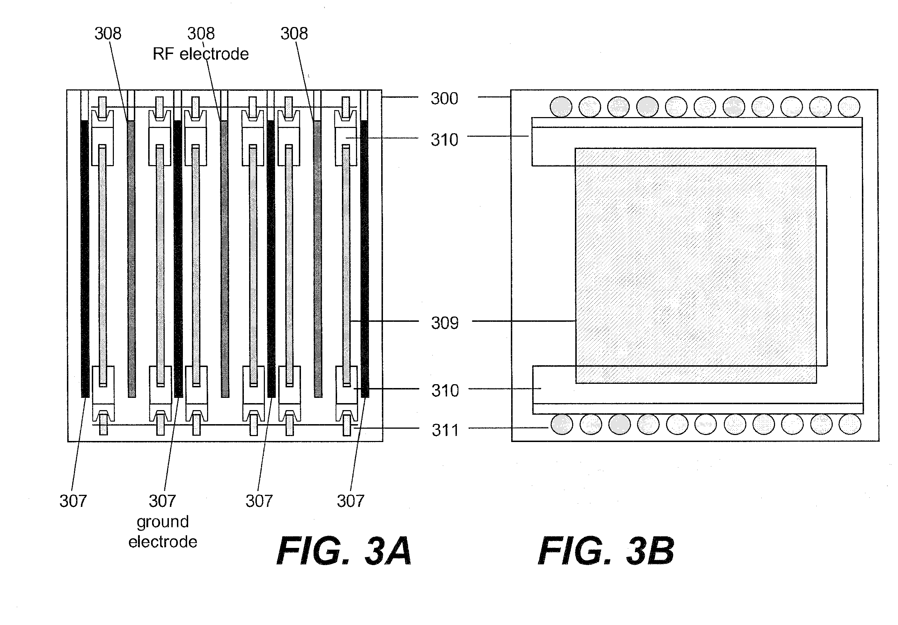

FIG. 3A and FIG. 3B show respectively a front view and a cross sectional view of a process chamber 300 that includes a plurality of fixtures. In other words, a platform now includes a plurality of fixtures, an exact number of which may be predetermined depending on the size of the chamber 300. Each of the fixtures is landed on an array of rollers 211, FIG. 3B shows that such a fixture 310 holding a workpiece 309, the front view of the fixture 310 may be seen as one of the six fixtures shown in FIG. 3A. It should be noted that each of the fixtures is landed on one set of roller 311 as shown in FIG. 3B. If necessary, each of the workpieces can be moved independently or together.

To transfer the fixtures 210 or fixtures 310 from a process chamber 200 or 300 or a load lock chamber 101 into a transfer chamber 105, the rotary stage 113 of the transfer chamber 105 is rotated until the rollers in the transfer chamber are aligned with the rollers in the process chamber 200 or the load lock chamber 101. Once aligned, the rollers are activated such that the fixture(s) is transferred in or out of the process chamber 200 or the load lock chamber 101. The rollers are stopped when the fixture reached a designated position inside the transfer chamber.

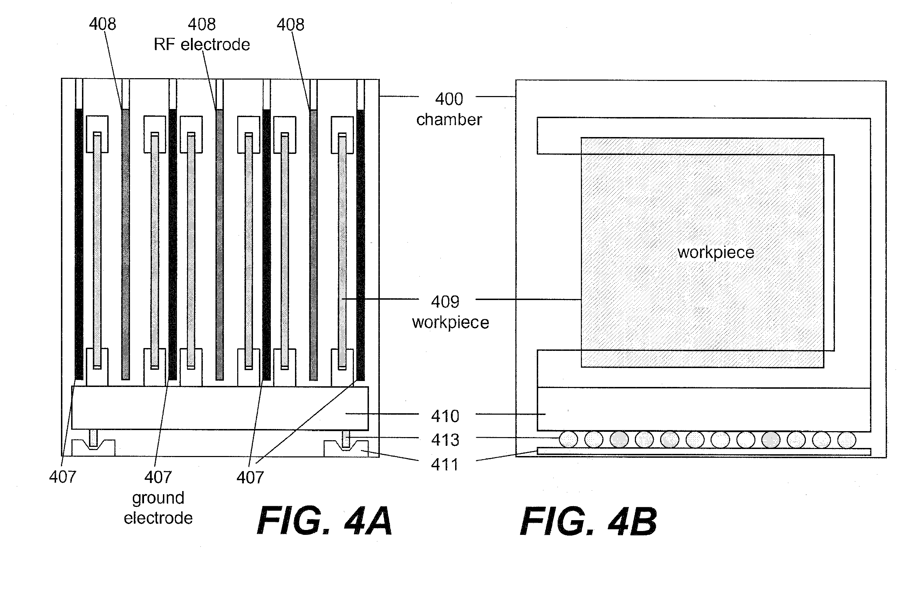

FIG. 2A, 2B, 3A or 3B shows that the fixture(s) is moved or transferred by an array of rollers or sets of rollers. Depending on implementation, there are other moving mechanisms that may be used to move a platform or fixture(s). One exemplary moving mechanism is to use rails to transfer the fixture(s). FIG. 4A and FIG. 4B show respectively a front view and a cross sectional view of a process chamber 400 that includes a fixture 410 with wheels 413 running on a set of rails 411. Similar rails may be also provided in the load lock chamber or the transfer chamber so that the fixture 410 can be transferred from one chamber to another. According to another embodiment, another set of rails may be mounted on the ceiling of the process chamber 400 to firmly guide the motion of the fixture 410.

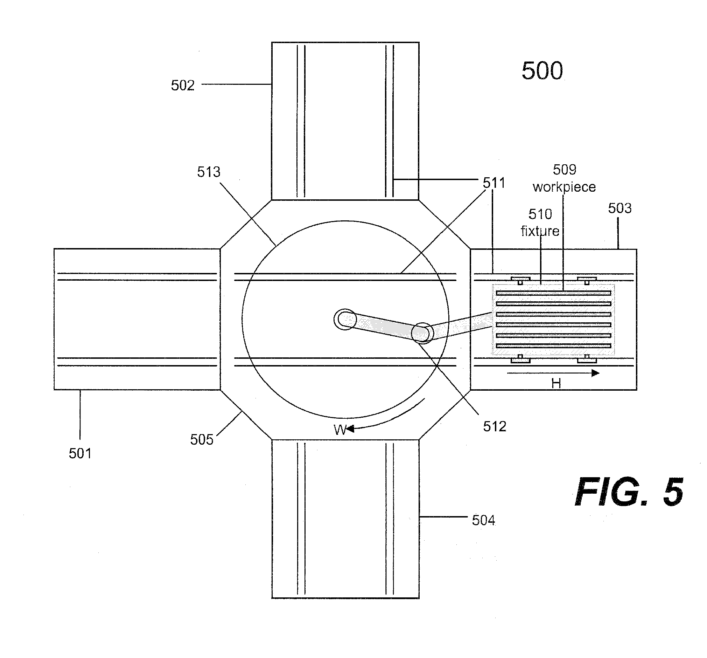

FIG. 5 shows an exemplary configuration 500 using a transfer device 512 to move a fixture from one chamber to another. According to one embodiment of the present invention, the configuration 500 includes a transfer chamber 505, one or more process chambers (only three representative chambers 502, 503 and 504 are shown) and one or more load lock chambers (only one representative chamber 501 is shown).

In one embodiment, to move the fixture from one chamber to another chamber, the transfer device is a mechanical arm extended towards the fixture in one chamber and then attached to the fixture. The mechanical arm is then retracted towards another chamber (e.g., the transfer chamber) while still attached to the fixture. As a result, the fixture is moved out of one chamber and moved into another chamber (e.g., the transfer chamber) along the rails in the horizontal direction, where it is assumed that the rails are aligned by the rotary stage 513. After the fixture is moved into the transfer chamber, the rotary stage is rotated until the rails are aligned with the destination chamber. The mechanical arm is then extended towards the destination chamber. As a result, the fixture is moved out of the transfer chamber and moved into the destination chamber. After the fixture is placed at the designated position, the mechanical arm is detached from the fixture and retracts back.

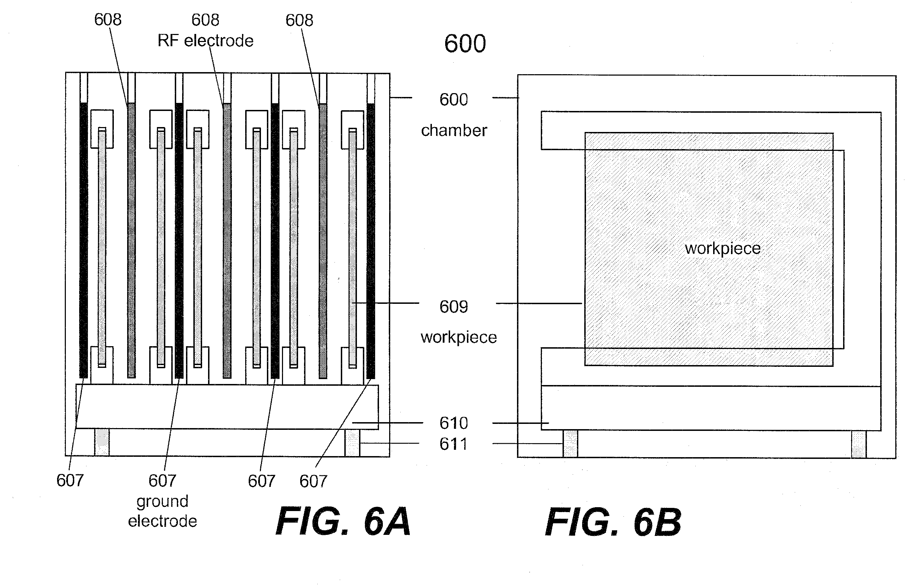

According to another embodiment, a mechanical manipulator is used to move the fixture. FIGS. 6A and 6B show respectively a front view and a cross sectional view of a process chamber 600 that includes a fixture 610. The fixture 610 is landed on a set of studs 611 that provides a space for the mechanical manipulator (e.g., a lifting mechanism) to extend towards the bottom of the fixture 610. The lifting mechanism raises the fixture 610 and retracted towards the center of the transfer chamber. As a result, the fixture is lifted and moved to the transfer chamber.

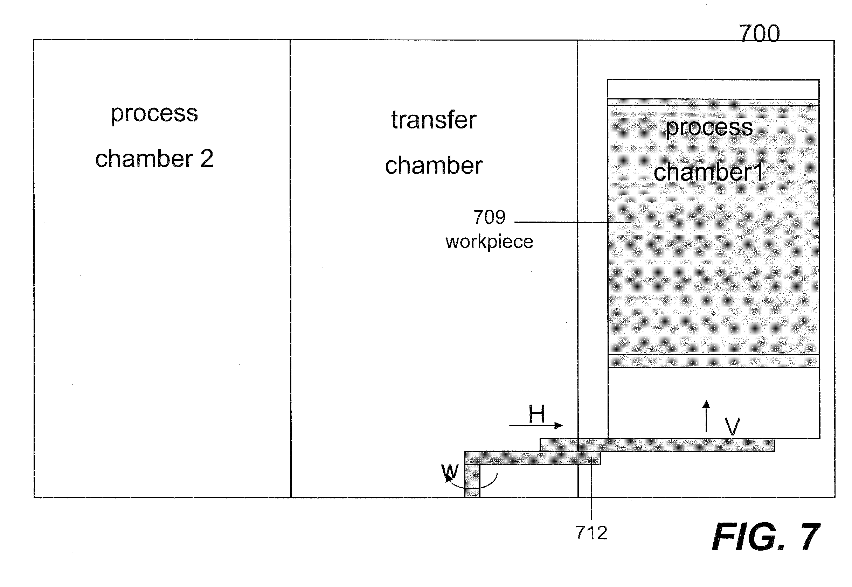

To move the fixture from the transfer chamber to a process chamber or the load lock chamber, the lifting mechanism holding the fixture is rotated until the fixture is aligned with the process chamber or the load lock chamber. Then, as shown in FIG. 7, the lifting mechanism 713 is extended towards the designated chamber. When the fixture reaches the designated position inside the designated chamber, the lifting mechanism is lowered and the fixture is placed in the designated chamber. The lifting mechanism is then retracted from the designated chamber into the transfer chamber.

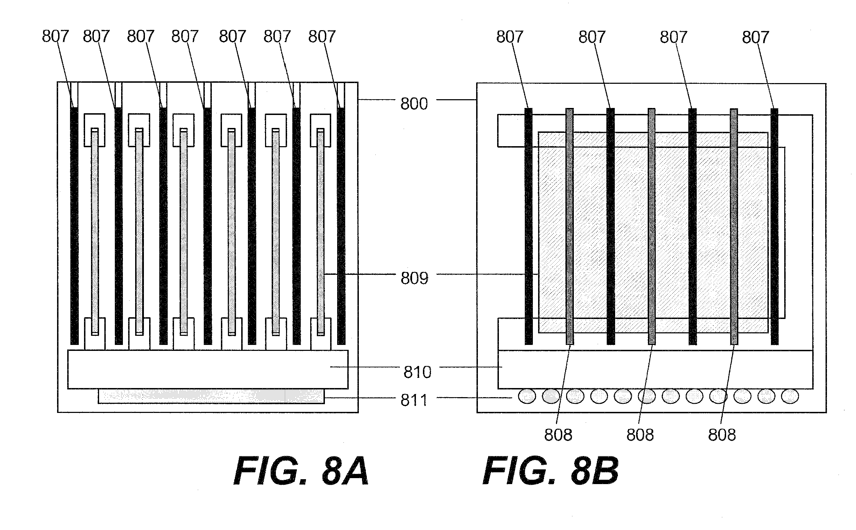

FIGS. 8A and 8B show together another embodiment in which RF electrodes 808 interleave the ground electrodes 807 along the planar surface of the workpiece 809. The workpiece is held in between a pair of electrode arrays using a fixture 810. The fixture 810 being landed on the rollers 811 allows the workpieces to be positioned in a narrow gap between the pair of electrode arrays.

The present invention discloses a system for handling workpieces in a chamber and between chambers. To effectively use the space in a chamber, the workpieces are vertically positions between a RF electrode and a ground electrode. To further effectively use the space in the chamber, in one embodiment, an odd number of RF electrodes is used to interleave the ground electrodes. Without moving the electrodes, workpieces can be moved in or out steadily a chamber by a moving mechanism together with a transfer chamber. The invention may be used in many applications, such as treating workpieces with chemical components. For example, one embodiment of the present invention can be advantageously used in plasma enhanced chemical vapor deposition (PECVD) that is a process mainly to deposit thin films from a gas state (vapor) to a solid state on some substrate.

In another embodiment, all electrodes are connected to the ground potential. For example, electrodes 207 and 208 in FIG. 2A are both connected to a ground potential. As a result, the workpieces are treated by chemical vapour deposition (CVD) in a process chamber. No plasma is excited. The process gas required by CVD is distributed through small holes on the electrodes so as to achieve even supply of process gas along the surface of workpieces in the chamber.

The present invention has been described in sufficient details with a certain degree of particularity. It is understood to those skilled in the art that the present disclosure of embodiments has been made by way of examples only and that numerous changes in the arrangement and combination of parts may be resorted without departing from the spirit and scope of the invention as claimed. Accordingly, the scope of the present invention is defined by the appended claims rather than the foregoing description of embodiments.

## Claims

1. A system for handling workpieces in chambers, the system comprising: a process chamber with a plurality of vertically aligned electrodes mounted in the process chamber; and a platform, including at least one fixture, that is removably positioned in the chamber to hold a plurality of workpieces vertically.

2. The system as recited in claim 1, wherein the platform is transferred using rollers.

3. The system as recited in claim 2, further comprising a rotary stage in a chamber having an opening connected to the process chamber.

4. The system as recited in claim 3, further comprising outlets arranged on at least one of the electrodes.

5. The system as recited in claim 1, wherein the platform is transferred using rails.

6. The system as recited in claim 5, further comprising a rotary stage with rails in a chamber having an opening connected to a process chamber.

7. The system as recited in claim 6, further comprising outlets arranged on at least one of the electrodes.

8. The system as recited in claim 7, further comprising a transfer device which provides a horizontal movement for transporting the fixture.

9. The system as recited in claim 1, further comprising a mechanical manipulator provided to move the platform in and out a chamber, where functions of the manipulator include: raising the platform; moving the platform in the horizontal direction; rotating the platform about a vertical axis.

10. The system as recited in claim 9, further comprising outlets arranged on at least one of the electrodes

11. A system for handling workpieces in chambers, the system comprising: at least a process chamber including a plurality of RF electrodes and ground electrodes; and a platform, being accommodated in the process chamber, including at least one fixture configured to hold a plurality of workpieces vertically, each of the workpieces being positioned between one of the RF electrodes and one of the ground electrodes, wherein, when the platform is caused to move out or in the process chamber by a moving mechanism, the workpieces are moved out or in the process chamber simultaneously.

12. The system as recited in claim 11, wherein the moving mechanism includes rollers, wheels running in rails and a transfer device, and studs or a manipulator.

13. The system as recited in claim 11, wherein the platform includes a plurality of fixtures, each configured to hold one of the workpieces.

14. The system as recited in claim 11, further comprising: a load lock chamber for receiving the workpieces and placing the workpieces in the platform; and a transfer chamber including a rotary stage being rotated to the load lock chamber to receive the platform from the load lock chamber.

15. The system as recited in claim 14, wherein there are N RF electrodes interleaving N+1 ground electrodes, where N is a finite odd integer.

16. The system as recited in claim 15, wherein the N RF electrodes is arranged symmetrically, each of the workpieces is placed between one of the RF electrodes and one of the N+1 ground electrodes with a back face closer to the one of the N+1 ground electrodes.

17. The system as recited in claim 11, wherein the platform includes a fixture with the holders to hold the workpieces steady, the fixture is placed on an array of rollers to be moved in or out the process chamber.

18. The system as recited in claim 11, wherein the platform includes a number of fixtures, each with a pair of holders to hold one of the workpieces steady and mounted with a set of rollers to be moved in or out the process chamber.

19. The system as recited in claim 11, wherein the platform includes a fixture with the holders to hold the workpieces steady, the fixture is placed on a set of studs to form a void underneath so that a mechanical arm can reach a bottom of the fixture to raise the fixture to be moved in or out the process chamber.

20. The system as recited in claim 11, further comprising a transfer device to transfer the platform in or out the process chamber.
